# EUROPEAN PATENT APPLICATION

(11) **EP 2 056 406 A1**
(43) Date of publication of application: **06.05.2009**
(21) Application number: 07792046.0
(22) Date of filing: 06.08.2007
(51) Int. Cl.: H01R 11/01, C09J 9/02, C09J 11/08, C09J 201/00, H01R 12/16, H01B 1/22, H05K 1/14, H05K 3/36

(54) **CIRCUIT CONNECTING MATERIAL, CONNECTION STRUCTURE FOR CIRCUIT MEMBER USING THE SAME AND PRODUCTION METHOD THEREOF**

(30) Priority: 25.08.2006 JP 2006229086; 21.11.2006 JP 2006314652; 18.06.2007 JP 2007160577
(71) Applicant: Hitachi Chemical Company, Ltd., Tokyo 163-0449 (JP)
(72) Inventor: TATSUZAWA, Takashi c/o Hitachi Chemical Company Ltd., Chikusei-shi, Ibaraki 308-8524 (JP); KOBAYASHI, Kouji c/o Hitachi Chemical Company Ltd., Chikusei-shi, Ibaraki 308-8524 (JP); FUKUSHIMA, Naoki c/o Hitachi Chemical Company Ltd., Chikusei-shi, Ibaraki 308-8524 (JP); KOBAYASHI, Takanobu c/o Hitachi Chemical Company Ltd., Chikusei-shi, Ibaraki 308-8524 (JP); ITO, Akihiro c/o Hitachi Chemical Company Ltd., Chikusei-shi, Ibaraki 308-8524 (JP)
(74) Representative: Jönsson, Hans-Peter
(86) International application number: PCT/JP2007/065376
(87) International publication number: WO 2008/023565

(57) **Abstract**

The circuit-connecting material of the present invention is a circuit-connecting material for connecting a first circuit component having a plurality of first circuit electrodes on a main surface of a first circuit board and a second circuit component having a plurality of second circuit electrodes on a main surface of a second circuit board, in such a manner that the first circuit electrodes and the second circuit electrodes are electrically connected while being opposed to one another; wherein the circuit-connecting material contains an adhesive composition, conductive particles, and a plurality of insulating particles containing one or both of polyamic acid particles and polyimide particles.

## Description

### Technical Field

The present invention relates to a circuit-connecting material, a connection structure for circuit member using the circuit-connecting material, and a method for producing the connection structure of the circuit member.

### Background Art

Anisotropic conductive adhesives containing conductive particles dispersed in an epoxy adhesive or an acrylic adhesive are widely used as circuit-connecting materials for electrically connecting opposing circuit electrodes. Such anisotropic conductive adhesives are used, for example, in TCP (Tape Carrier Package) mounting and COF (Chip-on-Flex) mounting for connecting panels such as panels of liquid crystal displays (LCDs) and substrates with semiconductors for driving LCDs mounted thereon.

In recent years, even when semiconductors are directly mounted face-down on LCD panels or printed wiring boards, flip-chip mounting, which is advantageous for smaller thickness and finer pitch connections, is being adopted in place of the conventional wire bonding process. The flip-chip mounting also uses an anisotropic conductive adhesive as a circuit-connecting material (see, for example, Patent Documents 1 to 4).

On the other hand, as COF, finer pitches and the like for LCD modules have become more prevalent, there is an ever-growing need to prevent short-circuits between neighboring electrodes. In order to meet such a need, a technique in which insulating particles are dispersed in the adhesive component of a circuit-connecting material to prevent short-circuits has been developed (see, for example, Patent Documents 5 to 9).

When insulating particles are dispersed, problems such as lowered adhesion of the circuit-connecting material and interfacial peeling between the substrate and the circuit-connecting portion tend to arise. For this reason, for cases where the substrate is made of an insulating organic material or glass, or cases where the substrate surface is made of silicon nitride, a silicone resin, a polyimide resin, or the like, the following methods have been developed: a method in which silicone particles are incorporated into a circuit-connecting material to improve the adhesion (see, for example, Patent Document 10); and a method in which rubber particles are dispersed in a circuit-connecting material to reduce the internal stress due to a difference in thermal expansion coefficient after bonding the substrate (see, for example, Patent Document 11).
Patent Document 1: Japanese Patent Laid-Open No. 59-120436
Patent Document 2: Japanese Patent Laid-Open No. 60-191228
Patent Document 3: Japanese Patent Laid-Open No. 1-251787
Patent Document 4: Japanese Patent Laid-Open No. 7-90237
Patent Document 5: Japanese Patent Laid-Open No. 51-20941
Patent Document 6: Japanese Patent Laid-Open No. 3-29207
Patent Document 7: Japanese Patent Laid-Open No. 4-174980
Patent Document 8: Japanese Patent No. 3048197
Patent Document 9: Japanese Patent No. 3477367
Patent Document 10: WO 01/014484
Patent Document 11: Japanese Patent Laid-Open No. 2001-323249

### Disclosure of the Invention

However, depending on the type of the material of the substrate used, the prevention of peeling at the interface between the substrate and the circuit-connecting portion is still insufficient. Since the interfacial peeling causes the connection reliability and connection appearance to deteriorate, a circuit-connecting component capable of sufficiently preventing interfacial peeling is required.

The present invention was made in view of the above-described circumstances. An object of the invention is to provide a circuit-connecting material that provides excellent connection reliability and an excellent connection appearance by preventing interfacial peeling between a circuit component and a circuit-connecting portion while maintaining good conductivity between opposing electrodes and good adhesion between opposing circuit components; a connection structure of circuit components using the circuit-connecting material; and a method for producing the connection structure of circuit components.

In order to achieve the above-described object, the circuit-connecting material of the invention is a circuit-connecting material for connecting a first circuit component having a plurality of first circuit electrodes on a main surface of a first circuit board and a second circuit component having a plurality of second circuit electrodes on a main surface of a second circuit board, in such a manner that the first circuit electrodes and the second circuit electrodes are electrically connected while being opposed to one another; the circuit-connecting material being characterized by comprising an adhesive composition, conductive particles, and a plurality of insulating particles containing one or both of polyamic acid particles and polyimide particles.

When the circuit-connecting material is interposed between the first and second circuit components to connect the first and second circuit components, interfacial peeling between each circuit component and the circuit-connecting portion can be prevented while maintaining high adhesion between the opposing circuit components. In this way, a circuit-connecting material can be obtained which exhibits an excellent effect of peeling prevention, and provides excellent connection reliability and an excellent connection appearance.

Although the reason for which these effects can be attained is not necessarily clear, it is presumed that the affinity between the circuit-connecting portion and the circuit components at their interfaces is improved by incorporating a plurality of insulating particles containing one or both of polyimide particles and polyamic acid particles in the circuit-connecting material.

In the present invention, the mass ratio of the insulating particles to the adhesive composition in the above-described circuit-connecting material is preferably from 0.001 to 0.5. This can result in a circuit-connecting material with high connection reliability, which exhibits an even superior effect of peeling prevention and superior adhesion simultaneously.

In the present invention, the mean particle diameter of the insulating particles is preferably greater than that of the conductive particles. In this way, the circuit-connecting material can be in such a state that the conductive particles are present in gaps formed by the plurality of insulating particles, so as to sufficiently prevent aggregation of the conductive particles. Thus, even if COF and finer pitches become more prevalent, the circuit-connecting material can be used to connect circuit electrodes or connection terminals, so as to sufficiently prevent short-circuits between neighboring electrodes on the same circuit component.

In the present invention, the mean particle diameter of the insulating particles contained in the above-described circuit-connecting material is preferably from 0.1 to 10 µm. This can improve the adhesive properties of the circuit-connecting material prior to curing by application of heat and pressure, thereby providing a circuit-connecting material that exhibits a high temporary-fixture ability to fix the circuit components to the circuit-connecting material, and exhibits an even superior effect of peeling prevention.

In the present invention, the insulating particles preferably have a 10% compressive elasticity modulus that is lower than that of the conductive particles. This can improve the flexibility of the insulating particles, so as to effectively prevent impairment of electrical conduction between opposing circuit electrodes or between opposing connection terminals due to the insulating particles. Thus, a circuit-connecting material with even higher connection reliability can be obtained.

In the present invention, the plurality of insulating particles preferably contain polyamic acid particles. Since polyamic acid particles are even softer than polyimide particles, the insulating particles 51 can easily deform to effectively prevent impairment of electrical conduction, while increasing the pressure applied to the conductive particles 53. Thus, a circuit-connecting material with even higher connection reliability can be obtained.

Moreover, the present invention provides a connection structure of circuit components comprising a first circuit component having a plurality of first circuit electrodes on a main surface of a first circuit board; a second circuit component having a plurality of second circuit electrodes on a main surface of a second circuit board, the second circuit electrodes being located so that they are opposed to the first circuit electrodes; and a circuit-connecting portion provided between the first circuit board and the second circuit board, to connect the first circuit component and the second circuit component in such a manner that the first and second circuit electrodes are electrically connected; wherein the circuit-connecting portion is made of the above-described circuit-connecting material.

This connection structure of circuit components, i.e., a circuit-connection structure, is formed using the circuit-connecting material with the above-described features. Thus, the connection structure maintains a high degree of adhesion between the opposing circuit components, has an excellent effect of peeling prevention, and provides excellent connection reliability and an excellent connection appearance.

Furthermore, the present invention provides a method for producing a connection structure of circuit components comprising the steps of locating a first circuit component having a plurality of first circuit electrodes on a main surface of a first circuit board and a second circuit component having a plurality of second circuit electrodes on a main surface of a second circuit board so that the first circuit electrodes and the second circuit electrodes are opposed to one another; and applying heat and pressure to the entire resulting structure, with the above-described circuit-connecting material being interposed between the first and second circuit components, thereby connecting the first circuit component and the second circuit component in such a manner that the first and second circuit electrodes are electrically connected.

Since this production method uses the circuit-connecting material with the above-described features, it can produce a connection structure that maintains a high degree of adhesion between the opposing circuit components, has an excellent effect of peeling prevention, and provides excellent connection reliability and an excellent connection appearance.

The present invention can provide a circuit-connecting material that provides excellent connection reliability and an excellent connection appearance by preventing interfacial peeling between a circuit component and a circuit-connecting portion while maintaining high conductivity between opposing electrodes and high adhesion between opposing circuit components; a connection structure of circuit components using the circuit-connecting material; and a method for producing the connection structure of circuit components.

### Brief Description of the Drawings

Figure 1 is a cross section showing one embodiment of the connection structure of circuit components of the present invention;
Figure 2 is a cross section showing one embodiment of the film-like circuit-connecting material of the present invention;
Figure 3 is a flowchart schematically showing the cross sections of the steps of a method for producing a connection structure of circuit components according to one embodiment of the present invention;
Figure 4 is a photograph of the appearance of a circuit-connection structure according to one embodiment of the present invention, taken from the LCD panel side;
Figure 5 is a photograph of the appearance of a circuit-connection structure according to another embodiment of the present invention, taken from the LCD panel side;
Figure 6 is a photograph of the appearance of a conventional circuit-connection structure taken from the LCD panel side; and
Figure 7 is a photograph of the appearance of another conventional circuit-connection structure taken from the LCD panel side.

### Description of Symbols

10: connection structure of circuit components, 20: circuit component (first circuit component), 21: circuit board (first circuit board), 21a: main surface, 22: circuit electrode (first circuit electrode), 30: circuit component (second circuit component), 31: circuit board (second circuit board), 31a: main surface, 32: circuit electrode (second circuit electrode), 40, 41: adhesive composition, 51: insulating particles, 53: conductive particles, 60: circuit-connecting portion, 61: film-like circuit-connecting material, 70: connection structure of circuit components, 72, 76: circuit electrode, 73: LCD panel, 74: liquid crystal display, 75: circuit board.

### Best Mode for Carrying Out the Invention

Referring to the drawings as required, preferred embodiments of the circuit-connecting material, the connection structure of circuit components, and the method for producing the connection structure of the present invention are hereinafter described. Throughout the drawings, like numerals represent like elements, and the same explanation is omitted. The term "(meth)acrylate" in each embodiment denotes an acrylate and the corresponding methacrylate.

### <Connection Structure of Circuit Components>

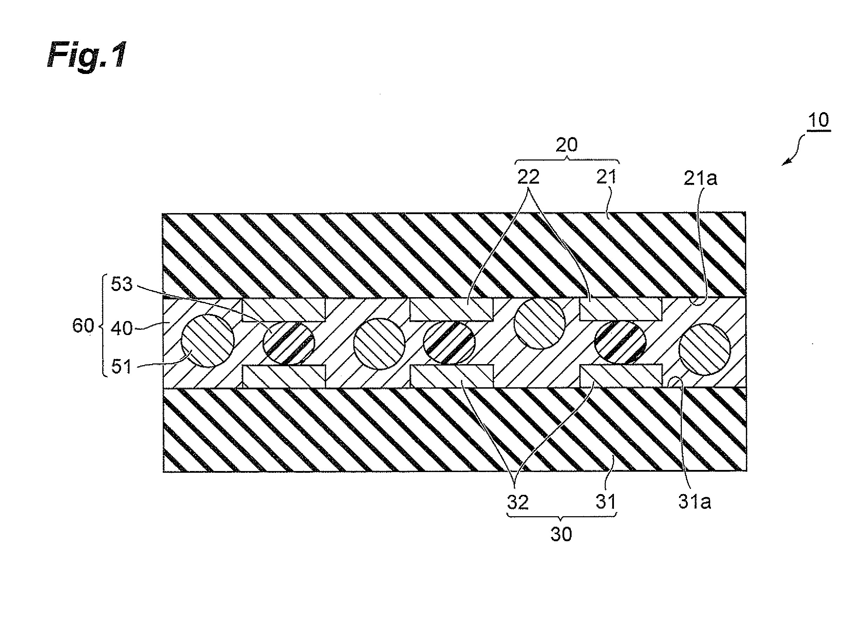

Figure 1 is a cross section showing one embodiment of the connection structure of circuit components of the present invention. The connection structure 10 of circuit components according to this embodiment includes a circuit component 20 (a first circuit component) and a circuit component 30 (a second circuit component) that are opposed to each other; and a circuit-connecting portion 60 that is located between the circuit component 20 and the circuit component 30 to connect these components.

The circuit component 20 has a circuit board 21 (a first circuit board), and a plurality of circuit electrodes 22 (first circuit electrodes) located on a main surface 21a of the circuit board 21. The circuit component 30 has a circuit board 31 (a second circuit board), and a plurality of circuit electrodes 32 (second circuit electrodes) located on a main surface 31a of the circuit board 31.

The circuit-connecting portion 60 is located between the main surface 21a of the circuit board 21 and the main surface 31a of the circuit board 31, to connect the circuit components 20 and 30 so that the circuit electrodes 22 and 32 are opposed to one another. The circuit-connecting portion 60 is made of a circuit-connecting material containing an adhesive composition 40, insulating particles 51, and conductive particles 53. The circuit-connecting material is described in detail later. The circuit component 20 and the circuit component 30 are electrically connected via the conductive particles 53.

The connection structure 10 of circuit components typically includes a large number of (or, in some cases, may include one each of) circuit electrodes 22 and 32. The circuit electrodes 22 and 32 can be formed using various conductive metals, metal oxides, or alloys alone or in a combination of two or more. Examples of metals include Zn, Al, Sb, Au, Ag, Sn, Fe, Cu, Pb, Ni, Pd, Pt, and the like, which can be used alone or in combination. Further, for special purposes such as, for example, adjusting the hardness or surface tension, and for improving the adhesion, other metals such as Mo, Mn, Cd, Si, Ta, Cr, and the like, as well as compounds thereof can be added to the above-mentioned metals. Among the above-mentioned metals, Ni, Ag, Au, Sn, Cu, and the like are preferably used in view of their good conductivity and corrosion resistance; these metals can be formed as a single layer or a plurality of layers.

Components usable as the circuit components 20, 30 include LCD panels, printed circuit boards, or chip components such as semiconductor chips, resistor chips, capacitor chips, and the like.

Specific examples of connection forms for the connection structure 10 of circuit components include connections of chip components such as IC chips, semiconductor chips, resistor chips, capacitor chips, and the like with substrates having chips mounted thereon such as printed circuit boards and the like; connections of electrical circuits; connections of glass substrates packaged by COG or COF with IC chips, and LCD panels with flexible printed circuit boards.

Insulating materials such as flexible tapes and glass can be used as the circuit boards 21, 31.

The connection structure 10 of circuit components is produced according to, for example, a method that includes the steps of locating at least some of the circuit electrodes 22 and 32 so that they are opposed to one another; placing the circuit-connecting material (an anisotropic conductive adhesive) between the opposing circuit electrodes, with the circuit electrodes 22 and 32 being opposed to one another; bringing the opposing circuit electrodes into direct contact by applying heat and pressure thereto, or electrically connecting the opposing circuit electrodes via the conductive particles 53 of the circuit-connecting portion 60. Upon application of heat at this time, the adhesive composition 40 in the circuit-connecting material is cured.

### <Film-Like Circuit-Connecting Material>

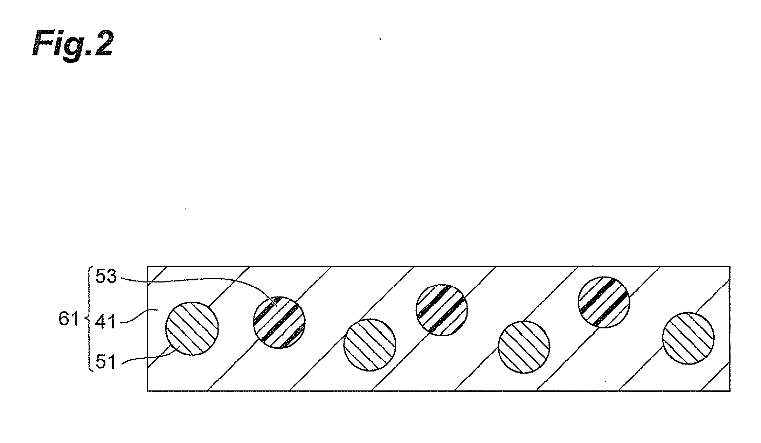

Figure 2 is a cross section showing one embodiment of the circuit-connecting material of the present invention. A film-like circuit-connecting material 61 contains an adhesive composition 41, conductive particles 53, and a plurality of insulating particles 51.

Polyamic acid particles substantially composed of a polyamic acid, or polyimide particles composed of a polyimide that is produced by heating a polyamic acid, are used as the insulating particles 51. Both of the polyamic acid particles and polyimide particles can be used at a given ratio as the insulating particles 51. The polyamic acid and polyimide can be suitably selected in consideration of their dispersibility to solvents such as toluene, methyl ethyl ketone, or ethyl acetate, and their solvent resistance.

Polyamic acid particles or polyimide particles which are nonconducting particles, i.e., the insulating particles 51, can be produced by, for example, imidizing a polyamide acid solution by heating. A polyamic acid, which has an amide group and a carboxyl group, is a polyimide precursor. The polyamic acid is converted to a polyimide when the amide group and carboxyl group are reacted by heating to produce an imido group. The polyamic acid is a polymer having, for example, a polymer chain represented by the following general formula:

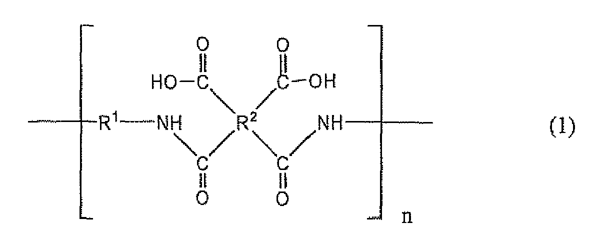

The polyimide produced from the polyamic acid is a polymer with an imido group in its principal chain, and has, for example, a polymer chain represented by the following general formula (2):

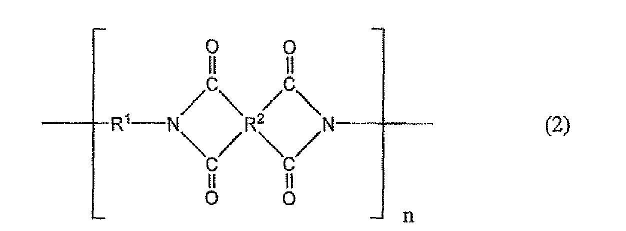

In formulae (1) and (2), R¹ is a residue resulting from the removal of the amino groups from a diamine, or a residue resulting from the removal of the isocyanate groups from a diisocyanate; R² is a residue resulting from the removal of the carboxylic acid derivative portion of an aromatic tetracarboxylic acid derivative; and n is an integer of 1 or more.

The polyamic acid can be synthesized by reacting one or both of a diamine and a diisocyanate with a tetracarboxylic acid or a derivative thereof.

Aromatic amines can be used as diamines. Specific examples of aromatic amines include aromatic diamines such as 4,4'-(or 3,4'-, 3,3'-, or 2,4'-)diaminodiphenyl ether, 4,4'-(or 3,3'-)diaminodiphenyl sulfone, 4,4'-(or 3,3'-)diaminodiphenyl sulfide, 4,4'-benzophenonediamine, 3,3'-benzophenonediamine, 4,4'-di(4-aminophenoxy)phenyl sulfone, 4,4'-di(3-aminophenoxy)phenyl sulfone, 4,4'-bis(4-aminophenoxy)biphenyl, 1,4-bis(4-aminophenoxy)benzene, 1,3-bis(4-aminophenoxy)benzene, 2,2-bis[4-(4-aminophenoxy)phenyl]propane, 3,3',5,5'-tetramethyl-4,4'-diaminodiphenylmethane, 4,4'-di(3-aminophenoxy)phenyl sulfone, 2,2'-bis(4-aminophenyl)propane, 2,2'-trifluoromethyl-4,4'-diaminobiphenyl, 2,2',6,6'-tetramethyl-4,4'-diaminobiphenyl, 2,2',6,6'-tetratrifluoromethyl-4,4'-diaminobiphenyl, bis[(4-aminophenyl)-2-propyl]1,4-benzene, 9,9-bis(4-aminophenyl)fluorene, and 9,9-bis(4-aminophenoxyphenyl)fluorene, 2,6-diaminopyridine, 2,4-diaminopyridine, bis(4-aminophenyl-2-propyl)-1,4-benzene, diaminopolysiloxane compounds, 2-nitro-1,4-diaminobenzene, 3,3'-dinitro-4,4'-diaminobiphenyl, 3,3'-dimethoxy-4,4'-diaminobiphenyl, 3,3'-dihydroxy-4,4'-diaminobiphenyl, 2,4-diaminophenol, o-tolidine sulfone, 1,3-diaminobenzene, 1,4-diaminobenzene, 2,4-diaminotoluene, 3,3'-dimethyl-4,4'-diaminobiphenyl, 2,2-bis(trifluoro)-methylbenzidine, 2,2-bis-(4-aminophenyl)propane, 1,1,1,3,3,3-hexafluoro-2-bis-(4-aminophenyl)propane, 4,4'-diaminodiphenylmethane, 1,5-diaminonaphthalene, 9,10-bis(4-aminophenyl)anthracene, and the like.

Examples of diisocyanates include those produced by reacting the above-mentioned diamines with phosgene and the like. Specific examples of diisocyanates include diphenylmethane diisocyanate, toluylene diisocyanate, and the like produced by substituting the amino groups of the above-mentioned diamines with isocyanate groups.

A tetracarboxylic acid with two pairs of two neighboring carboxyl groups is used as a tetracarboxylic acid that is reacted with a diamine. Specific examples of tetracarboxylic acids include pyromellitic dianhydride (1,2,3,4-benzenetetracarboxylic dianhydride), 3,4,3',4'-biphenyltetracarboxylic dianhydride, 3,4,3',4'-benzophenonetetracarboxylic dianhydride, 2,3,2,3'-benzophenonetetracarboxylic dianhydride, 2,3,3',4'-biphenyltetracarboxylic dianhydride, 2,2-bis(3,4-dicarboxyphenyl)propane dianhydride, 2,2-bis(2,3-dicarboxyphenyl)propane dianhydride, bis(3,4-dicarboxyphenyl)ether dianhydride, bis(2,3-dicarboxyphenyl)ether dianhydride, bis(3,4-dicarboxyphenyl)sulfone dianhydride, bis(2,3-dicarboxyphenyl)sulfone dianhydride, 4,4'-[2,2,2-trifluoro-1-(trifluoromethyl)ethylidene]bis(1,2-benzene dicarboxylic anhydride), 9,9-bis[4-(3,4-dicarboxyphenoxy)phenyl]fluorene dianhydride, 1,2,5,6-naphthalenetetracarboxylic dianhydride, 2,3,6,7-naphthalenetetracarboxylic dianhydride, 1,4,5,8-naphthalenetetracarboxylic dianhydride, 3,4,9,10-perylenetetracarboxylic dianhydride, 2,3,5,6-pyridinetetracarboxylic dianhydride, bicyclo(2,2,2)-oct-7-ene-2,3,5,6-tetracarboxylic dianhydride, and the like.

The amount of the insulating particles 51 is preferably from 0.1 to 30 parts by mass, more preferably from 0.5 to 20 parts by mass, and still more preferably from 0.5 to 10 parts by mass, based on 100 parts by mass of the adhesive composition 41. If the amount of the insulating particles is less than 0.1 parts by mass, the proportion of the insulating particles at the interface between each of the circuit components 20 and 30 and the circuit-connecting portion 60 will decrease, often reducing the effect of preventing interfacial peeling. On the other hand, if the amount of the insulating particles exceeds 30 parts by mass, the cohesive force of the adhesive will decrease, often reducing the adhesion between each of the circuit components 20 and 30 and the circuit-connecting portion 60.

The insulating particles 51 contained in the circuit-connecting material 61 of this embodiment preferably contain polyamic acid particles composed of polyamic acid. Since polyamic acid particles are less crosslinked than polyimide particles, they tend to be softer than polyimide particles. Thus, when the opposing circuit components are connected by applying heat and pressure to the circuit-connecting material 61, the insulating particles 51 can easily deform to effectively prevent impairment of electrical conduction, while increasing the pressure applied to the conductive particles 53, thereby reducing the connection resistance between the opposing electrodes.

The mean particle diameter of the insulating particles 51 is preferably from 0.1 to 10 µm, more preferably from 2 to 10 µm, and still more preferably from 3 to 5 µm. If the mean particle diameter of the insulating particles is less than 0.1 µm, the number of the insulating particles in the circuit-connecting material at the same concentration increases to reduce the adhesive properties of the circuit-connecting material prior to curing, often reducing the temporary-fixture ability to fix the circuit components 20 and 30 with the circuit-connecting material. On the other hand, if the mean particle diameter of the insulating particles exceeds 10 µm, the number of the insulating particles in the adhesive decreases to reduce the proportion of the insulating particles at the interface between each of the circuit components 20 and 30 and the circuit-connecting portion 60, often resulting in a poor effect of preventing interfacial peeling.

In the present invention, the particle diameters and mean particle diameters of the insulating particles 51 and the conductive particles 53 can be measured as follows. From a particle image of each of the insulating particles and conductive particles which has been magnified by 3,000 times with a scanning electron microscope (SEM: in the present invention, S800, manufactured by HITACHI, Ltd.), at least 30 particles are randomly selected. Using the magnified particle image, the maximum particle diameter and minimum particle diameter of the plurality of selected particles are measured for each of the insulating particles and conductive particles. The square root of the product of the maximum and minimum particle diameters is then calculated for each of the insulating particles and conductive particles, and the result is determined as the particle diameter of a single particle. Further, the particle diameter of a single particle is evaluated for each of the plurality of selected particles, and the value obtained by dividing the sum of these particle diameters by the number of the measured particles is determined as the mean particle diameter.

In this embodiment, the mean particle diameter of the insulating particles 51 (R1) is preferably greater than the mean particle diameter of the conductive particles 53 (R2). When R1>R2, the circuit-connecting material after curing can be in such a state that the conductive particles 53 are present in gaps formed by the plurality of insulating particles 51, thereby sufficiently preventing aggregation of the conductive particles 53. This can sufficiently prevent short-circuits between neighboring circuit electrodes on the same circuit component. Moreover, increasing R1 reduces the number of insulating particles contained in the circuit-connecting material, thus facilitating crosslinking of the adhesive composition. This can improve the cohesive force, etc., thereby improving the adhesion. On the other hand, if R1≤R2, the insulating particles 51 fill the gaps present among the plurality of conductive particles 53, often failing to sufficiently prevent aggregation of the conductive particles 51. Thus, short-circuits between neighboring circuit electrodes cannot be sufficiently prevented. Moreover, if R1 is much smaller than R2, the insulating particles 51 may become smaller than the gaps between the opposing circuit electrodes (which are typically from 10 to 30% of the diameter of the conductive particles). In this case, the probability that the insulating particles 51 are present at the interface between each of the circuit electrodes 22 and 32 and the circuit-connecting portion 60 decreases, often reducing the effect of preventing interfacial peeling.

In this embodiment, the ratio of the mean particle diameter (R1) of the insulating particles 51 relative to the mean particle diameter (R2) of the conductive particles 53 (R1/R2) is more preferably from 120 to 280%. A ratio of the mean particle diameters (R2/R1) of from 120 to 280% can sufficiently prevent short-circuits between neighboring circuit electrodes on the same circuit component, while sufficiently reducing the connection resistance between opposing circuit electrodes, and can also further improve the adhesion. Thus, a circuit-connecting material having, in particular, excellent connection reliability can be obtained.

If the ratio of the mean particle diameters (R1/R2) is less than 120%, short-circuits between neighboring circuit electrodes on the same circuit component cannot be sufficiently prevented; whereas, if the ratio of the mean particle diameters (R1/R2) exceeds 280%, the pressure applied to the conductive particles 53 will be distributed in the circuit-connecting portion 60, often resulting in a high connection resistance.

The insulating particles 51 preferably have a certain degree of flexibility. If the insulating particles have flexibility, the chances that the conductive particles ensure electrical conduction between opposing circuit electrodes can increase. For this reason, it is preferable that the insulating particles 51 have a 10% compressive elasticity modulus (a K-value) that is lower than the K-value of the conductive particles 53. This can improve the flexibility of the insulating particles 51 to effectively prevent impairment of electrical conduction between the opposing circuit electrodes 22 and 32 due to the insulating particles 51. It is more preferable that the insulating particles 51 have a 10% compressive elasticity modulus (a K-value) of from 1 to 1,000 kgf/mm², to further ensure electrical conduction between the opposing circuit electrodes 22 and 32. Electrical conduction via the conductive particles 53 in the connection structure of circuit components can also be accomplished by changing the conditions of applying heat and pressure, etc., when making a connection; however, when the insulating particles 51 possess the above-described flexibility-related properties, a circuit-connecting material with, in particular, excellent connection reliability can be obtained.

The term "10% compressive elasticity modulus (K-value)" herein refers to the elasticity modulus measured when the insulating particles 51 or conductive particles 53 experience a 10% compressive deformation, and can be measured using a micro-hardness meter, H-100, manufactured by Fischer Instruments, Co., Ltd.

Metal particles such as Au, Ag, Ni, Cu, or solder, or carbon, etc., can be used as the conductive particles 53. The conductive particles 53 can be prepared by, for example, coating a core material that forms the central portion with one or more coating layers. In this case, the outermost layer of the coating layers of the conductive particles 53 is a conductive layer.

For example, the conductive particles 53 can be prepared by coating the surface of a transition metal such as Ni with a precious metal such as Au. The conductive particles may also be prepared by coating insulating particles such as non-conductive glass, ceramics, or plastics with a conductive material such as a metal. To provide a sufficient pot life, precious metals such as Au, Ag, platinum group metals, and the like are preferred to transition metals such as Ni, Cu, and the like, for use as the outermost layer of the conductive particles; among such precious metals, Au is the most preferable.

When the conductive particles 53 become deformed by application of heat and pressure, the connection area between opposing circuit electrodes can increase during the formation of a connection structure of circuit components, thereby improving the connection reliability. For this reason, it is preferable that, for example, heat-molten metal particles be used as the conductive particles, or plastic particles be used as the core material of the conductive particles.

When a precious metal layer is formed as the outermost layer of the conductive particles 53, it is generally preferable that the thickness of the precious metal layer be from 100 Å or more, to provide good resistance. However, even if the thickness is 100 Å or more, when a precious metal coating layer is formed as the outer side of a transition metal such as Ni, the transition metal such as Ni may become exposed because of defects in the precious metal coating layer, or defects in the precious metal coating layer caused when mixing and dispersing the conductive particles. As a result, a free radical may be produced by the oxidation-reduction effect of the transition metal such as Ni, possibly resulting in a shortened pot life. For this reason, when a radically polymerizable component is used as the adhesive composition, the thickness of the precious metal coating layer is preferably 300 Å or more.

The amount of the conductive particles 53 is preferably from 0.1 to 30 parts by volume based on 100 parts by volume of the adhesive composition 41. To ensure the prevention of, for example, short-circuits between neighboring circuits due to the conductive particles, the amount of the conductive particles 53 is more preferably from 0.1 to 10 parts by volume.

The conductive particles 53 preferably have a 10% compressive elasticity modulus (a K-value) of from 100 to 1,000 kgf/mm², to stabilize the connection resistance and maintain good connection reliability.

An adhesive composition containing thermosetting components is suitably used as the adhesive composition 41. The adhesive composition 41 can contain, as thermosetting components, (a) an epoxy resin and (b) a latent curing agent, or (c) a radically polymerizable substance and (d) a free radical initiator. The adhesive composition 41 can also contain (a) an epoxy resin, (b) a latent curing agent, (c) a radically polymerizable substance, and (d) a free radical initiator.

Examples of epoxy resins usable as the epoxy resin (a) include bisphenol-type epoxy resins derived from epichlorohydrin and bisphenol A, bisphenol F, and/or bisphenol AD; epoxy novolak resins derived from epichlorohydrin and phenol novolac or cresol novolac; naphthalene-based epoxy resins having a skeleton containing a naphthalene ring; and various epoxy compounds with two or more glycidyl groups per molecule, such as glycidyl amines, glycidyl ethers, biphenyls, and alicyclic epoxy compounds.

These compounds can be used alone or as a mixture of two or more as the epoxy resin (a). A high-purity epoxy resin, in which impurity ions (Na⁺, Cl⁻, etc.), hydrolyzable chlorine, and the like have been reduced to 300 ppm or less, is preferably used to prevent electron migration.

As the latent curing agent (b), imidazoles, hydrazides, boron trifluoride-amine complexes, sulfonium salts, amine imides, polyamine salts, dicyandiamide, and the like can be used alone or as a mixture of two or more.

To extend the pot life, the latent curing agent is preferably coated with, for example, a polymer such as a polyurethane or polyester to microencapsulate the curing agent.

The term "radically polymerizable substance" (c) refers to a radically polymerizable substance containing a functional group. Examples of radically polymerizable substances include acrylates, methacrylates, maleimide compounds, etc.

Examples of acrylates and methacrylates include urethane acrylate, methyl acrylate, ethyl acrylate, isopropyl acrylate, isobutyl acrylate, ethylene glycol diacrylate, diethylene glycol diacrylate, triethylene glycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenylacrylate, tricyclodecanyl acrylate, bis(acryloxyethyl)isocyanurate, ε-caprolactone-modified tris(acryloxyethyl)isocyanurate, tris(acryloxyethyl)isocyanurate, etc. These various compounds can be used alone or in a combination of two or more.

When a radically polymerizable substance with a phosphoric ester structure is used, the amount of the radically polymerizable substance is preferably from 0.1 to 10 parts by mass, and more preferably from 0.5 to 5 parts by mass, based on 100 parts by mass of the adhesive composition 41, to improve the adhesive strength on the surface of an inorganic material such as a metal.

A radically polymerizable substance with a phosphoric ester structure is obtained as a reaction product of phosphoric anhydride and 2-hydroxy (meth)acrylate. More specifically, 2-methacryloyloxyethyl acid phosphate, 2-acryloyloxyethyl acid phosphate, etc., can be mentioned. These compounds can be used alone or in a combination of two or more.

Preferable maleimide compounds are those containing at least two maleimide groups per molecule; examples include 1-methyl-2,4-bismaleimide benzene, N,N-m-phenylene bismaleimide, N,N'-P-phenylene bismaleimide, N,N'-m-toluylene bismaleimide, N,N'-4,4-biphenylene bismaleimide, N,N'-4,4-(3,3'-dimethyl-biphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethane bismaleimide, N,N'-4,4-diphenylpropane bismaleimide, N,N'-4,4-diphenyl ether bismaleimide, N,N'-3,3'-diphenylsulfone bismaleimide, 2,2-bis[4-(4-maleimidephenoxy)phenyl]propane, 2,2-bis[3-s-butyl-4,8-(4-maleimidephenoxy)phenyl]propane, 1,1-bis[4-(4-maleimidephenoxy)phenyl]decane, 4,4'-cyclohexylidene-bis[1-(4-maleimidephenoxy)-2-cyclohexyl]benzene, 2,2-bis[4-(4-maleimidephenoxy)phenyl]hexafluoropropane, etc. These compounds can be used alone or in a combination of two or more. These compounds can also be used together with allyl compounds such as allylphenol, allylphenyl ether, allyl benzoate, etc.

To facilitate temporary fixing of the circuit components prior to curing of the adhesive composition, the radically polymerizable substance (c) described above preferably has a viscosity of from 100,000 to 1,000,000 mPa·s (25°C), and more preferably from 100,000 to 500,000 mPa·s (25°C). The viscosity of the radically polymerizable substance can be measured using a commercially available E-type viscometer.

Among the examples of radically polymerizable substance (c), urethane acrylate or urethane methacrylate is preferable in view of its good adhesive properties. To improve the heat resistance, it is particularly preferable that a radically polymerizable substance be used together such that the polymer after bridging with an organic peroxide described below independently has a Tg of 100°C or more. As such a radically polymerizable substance, a radically polymerizable substance containing at least one of a dicyclopentenyl group, a tricyclodecanyl group, and a triazine ring can be used. A radically polymerizable substance containing a tricyclodecanyl group or a triazine ring is particularly suitably used.

The term "free radical initiator" (d) refers to a curing agent that produces a free radical when it is heated or exposed to light. Examples of the free radical initiator include those that are decomposed by heating to produce free radicals, such as peroxide compounds, azo compounds, etc. The free radical initiator is suitably selected according to the target connection temperature, connection time, pot life, etc., but is preferably an organic peroxide having a temperature of 40°C or more after a half life of 10 hours, and has a temperature of 180°C or less after a half life of 1 minute, to provide high reactivity and a good pot life. In this case, the amount of the free radical initiator is preferably from 0.05 to 10 parts by mass, and more preferably from 0.1 to 5 parts by mass, based on 100 parts by mass of the adhesive composition 41.

Specific examples of compounds usable as the free radical initiator (d) include diacyl peroxides, peroxydicarbonates, peroxyesters, peroxyketals, dialkyl peroxides, hydroperoxides, etc. Among these examples, peroxyesters, dialkyl peroxides, and hydroperoxides are preferable because they can prevent corrosion of the circuit electrodes of the circuit components, with peroxyesters being more preferable to provide high reactivity.

Examples of usable diacyl peroxides include isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxy toluene, benzoyl peroxide, etc.

Examples of usable peroxydicarbonates include di-n-propyl peroxydicarbonate, diisopropyl peroxydicarbonate, bis(4-t-butylcyclohexyl)peroxydicarbonate, di-2-ethoxymethoxy peroxydicarbonate, di(2-ethylhexylperoxy)dicarbonate, dimethoxybutylperoxy dicarbonate, di(3-methyl-3-methoxybutylperoxy)dicarbonate, etc.

Examples of usable peroxyesters include cumyl peroxyneodecanoate, 1,1,3,3-tetramethylbutyl peroxyneodecanoate, 1-cyclohexyl-1-methylethyl peroxyneodecanoate, t-hexyl peroxyneodecanoate, t-butyl peroxypivalate, 1,1,3,3-tetramethyl butyl peroxy-2-ethylhexanonate, 2,5-dimethyl-2,5-bis(2-ethylhexanoylperoxy)hexane, 1-cyclohexyl-1-methylethyl peroxy-2-ethylhexanonate, t-hexyl peroxy-2-ethylhexanonate, t-butyl peroxy-2-ethylhexanonate, t-butyl peroxy isobutylate, 1,1-bis(t-butylperoxy)cyclohexane, t-hexyl peroxy isopropyl monocarbonate, t-butyl peroxy-3,5,5-trimethylhexanonate, t-butyl peroxy laurate, 2,5-dimethyl-2,5-bis(m-toluoylperoxy)hexane, t-butyl peroxy isopropyl monocarbonate, t-butyl peroxy-2-ethylhexyl monocarbonate, t-hexyl peroxy benzoate, t-butyl peroxy acetate, etc.

Examples of usable peroxy ketals include 1,1-bis(t-hexylperoxy)-3,5,5-trimethylcyclohexane, 1,1-bis(t-hexylperoxy)cyclohexane, 1,1-bis(t-butylperoxy)-3,5,5-trimethylcyclohexane, 1,1-(t-butylperoxy)cyclododecane, 2,2-bis(t-butylperoxy)decane, etc.

Examples of usable dialkyl peroxides include α,α'-bis(t-butylperoxy)diisopropylbenzene, dicumyl peroxide, 2,5-dimethyl-2,5-di(t-butylperoxy)hexane, t-butyl cumyl peroxide, etc.

Examples of usable hydroperoxides include diisopropylbenzene hydroperoxide, cumene hydroperoxide, etc.

These compounds can be used alone or in a combination of two or more as the free radical initiator (d).

The adhesive composition 41 may contain, in addition to the above-described components, a decomposition accelerator, inhibitor, etc. Further, as required, a polymerization inhibitor such as a hydroquinone or a methyl ether hydroquinone may be suitably used.

The film-like circuit-connecting material 61 composed of the above-described components maintains a connection as follows: when connecting the circuit components, the adhesive composition 41 is melted, causing the components of the circuit-connecting material to flow, and connect the opposing circuit components, after which the adhesive composition 41 is cured. Thus, the fluidity of the film-like circuit-connecting material 61 is an important factor.

The fluidity of the film-like circuit-connecting material 61 can be quantified and evaluated by, for example, the following procedure. A sample of the circuit-connecting material with a thickness of 35 µm and a size of 5 x 5 mm is placed between glass sheets with a thickness of 0.7 mm and a size of 15 x 15 mm, and then subjected to heat and pressure for 10 seconds at 170°C and 2 MPa. From the initial area (A) and the area after the application of heat and pressure (B), the fluidity (B)/(A) can be calculated. The value of fluidity (B)/(A) is preferably from 1.3 to 3.0, and more preferably from 1.5 to 2.5. If the value of (B)/(A) is less than 1.3, the fluidity will become poor, and a good connection of circuit components cannot be often obtained. On the other hand, if the value of (B)/(A) exceeds 3.0, bubbles tend to form, often resulting in poor connection reliability.

The circuit-connecting material at 40°C after curing preferably has an elasticity modulus of from 100 to 3,000 MPa, more preferably from 500 to 2,000 MPa, and still more preferably from 1,100 to 1,900 MPa, to stabilize the connection resistance and maintain good connection reliability. The elasticity modulus can be measured using a micro-hardness meter, H-100, manufactured by Fischer Instruments, Co., Ltd.

In addition to the adhesive composition 41, the insulating particles 51, and the conductive particles 53, the film-like circuit-connecting material 61 of this embodiment may contain a filler, a softener, an accelerator, an antioxidant, a colorant, a flame retardant, a thixotropic agent, a coupling agent, a phenol resin, a melamine resin, an isocyanate, etc.

The film-like circuit-connecting material 61 preferably contains a filler to improve the connection reliability and the like. Any filler can be used as long as the maximum diameter thereof is less than the mean particle diameter of the conductive particles 53. The amount of the filler is preferably from 5 to 60 parts by volume based on 100 parts by volume of the adhesive composition. If the amount of the filler exceeds 60 parts by volume, the effect of improving the connection reliability of the connection structure of circuit components cannot be often obtained.

As the coupling agent for use in the film-like circuit-connecting material 61, a compound containing one or more groups selected from the group consisting of vinyl, acrylic, amino, epoxy, and isocyanate groups is preferably used to improve the adhesive properties.

The circuit-connecting material of the present invention can become easy to handle when it is made into a film. In this case, a polymer component for imparting film formability is preferably incorporated into the circuit-connecting material. Examples of usable polymer components include polystyrene, polyethylene, polyvinyl butyral, polyvinyl formal, polyimide, polyamide, polyester, polyvinyl chloride, polyphenylene oxide, urea resins, melamine resins, phenol resins, xylene resins, epoxy resins, polyisocyanate resins, phenoxy resins, polyimide resins, polyester urethane resins, etc. Among the above, polyester urethane resins are preferable.

Compounds with aromatic or aliphatic ring structures, for example, can be used as polyester urethane resins.

Among the above-mentioned film-formable polymers, a resin with a functional group such as a hydroxy group is preferable to improve the adhesive properties. Moreover, a film-formable polymer obtained by modifying any of the above-mentioned film-formable polymers with a radically polymerizable functional group can be used. The film-formable polymer preferably has a weight average molecular weight of 10,000 to 1,000,000. If the weight average molecular weight of the film-formable polymer exceeds 1,000,000, the ease of mixing during the preparation of the circuit-connecting material often decreases.

The film-like circuit-connecting material 61 is useful as an adhesive for bonding an IC chip and a substrate, or bonding electrical circuits. The connection structure of circuit components, i.e., the circuit-connection structure, can be obtained by locating a first circuit component having first circuit electrodes (connection terminals) and a second circuit component having second circuit electrodes (connection terminals) so that the first circuit electrodes and the second circuit electrodes are opposed to one another; and, with the film-like circuit-connecting material 61 being interposed between the opposing first and second circuit electrodes, applying heat and pressure to the resulting structure, thereby electrically connecting the opposing first circuit electrodes and the second electrodes.

### <Method for Producing a Connection Structure of Circuit Components>

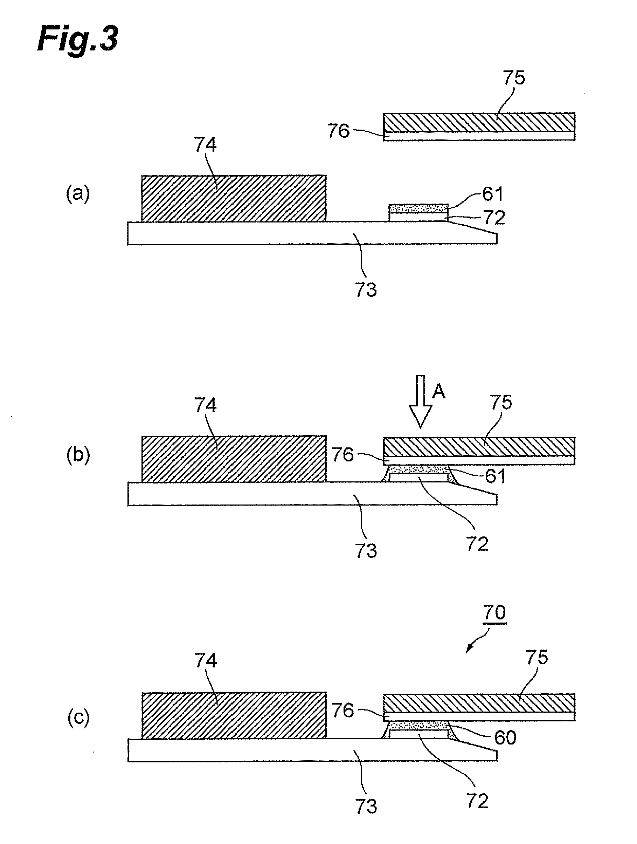

One embodiment of the method for producing a connection structure of circuit components according to the present invention is next described. Figure 3 is a flowchart schematically showing the cross sections of the steps of a method for producing a connection structure of circuit components according to one embodiment of the present invention. Figure 3 (a) is a cross section of circuit components before they are connected; Figure 3 (b) is a cross section of a connection structure of circuit components when the circuit components are connected; and Figure 3 (c) is a cross section of a connection structure of circuit components after the circuit components are connected.

First, as shown in Figure 3 (a), a film-like circuit-connecting material 61 obtained by forming the circuit-connecting material into a film is placed on a circuit electrode 72 located on an LCD panel 73.

Then, as shown in Figure 3 (b), a circuit board 75 having a circuit electrode 76 thereon is placed on the film-like circuit-connecting material 61, while positioning the circuit board 75 so that the circuit electrode 72 and the circuit electrode 76 are opposed to each other, with the result that the film-like circuit-connecting material 61 is interposed between the circuit electrode 72 and the circuit electrode 76. The circuit electrodes 72 and 76 have such a structure that a plurality of electrodes are aligned in the depth direction (not shown).

The film-like circuit-connecting material 61 is easy to handle because of its film-like shape. Therefore, the film-like circuit-connecting material 61 can be easily interposed between the circuit electrode 72 and the circuit electrode 76, thereby facilitating the operation of connecting the LCD panel 73 and the circuit board 75.

Subsequently, a pressure is applied to, while heating, the film-like circuit-connecting material 61 via the LCD panel 73 and the circuit board 75 in the direction of the arrow A of Figure 3 (b), thereby curing the circuit-connecting material 61. This results in a connection structure 70 of circuit components, wherein the circuit components are connected together, as shown in Figure 3 (c). As the curing method, one or both of heating and light radiation can be employed according to the adhesive composition used.

Conventionally, between neighboring circuit electrodes 72 on the LCD panel 73, peeling at the interface between the LCD panel 73 and the circuit-connecting portion 60 occurred, making the connection reliability and connection appearance poor. Using the film-like circuit-connecting material 61 of this embodiment, however, between neighboring circuit electrodes 72 on the LCD panel 73, peeling at the interface between the LCD panel 73 and the circuit-connecting portion 60, and more specifically, the interface between the passivation film such as SiN or SiO₂ formed as the outermost layer of the LCD panel 73 and the circuit-connecting portion 60, can be prevented. This can result in a connection structure of circuit components with excellent connection reliability and an excellent connection appearance.

Whether a connection structure of circuit components that is formed using the connecting material for circuit components of the present invention has an excellent connection appearance can be evaluated by observing the appearance of a circuit-connection structure wherein, for example, an LCD panel and a substrate having a semiconductor for driving the LCD mounted thereon are connected, under an optical microscope (for example, manufactured by Olympus Corporation; tradename: BH2-MJL).

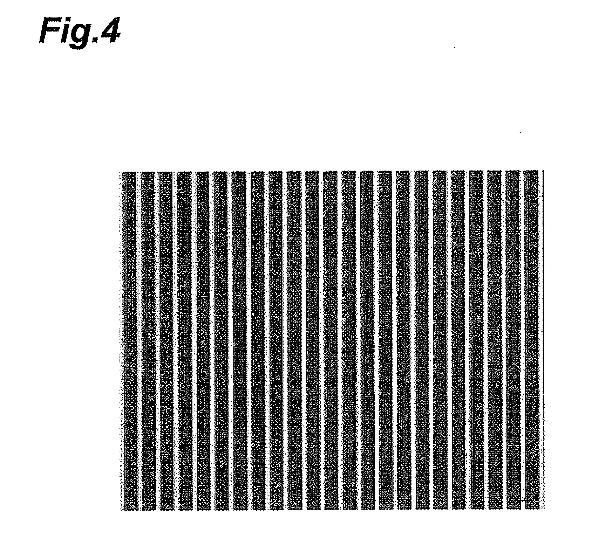

Figure 4 is a photograph of the appearance of a circuit-connection structure according to one embodiment of the present invention, taken from the LCD panel side. The circuit-connection structure is formed using a circuit-connecting material that contains, based on 100 parts by mass of an adhesive composition, 10 parts by mass of polyimide particles with a particle diameter of 3 µm, and 6 parts by mass of polystyrene-containing conductive particles with a particle diameter of 4 µm.

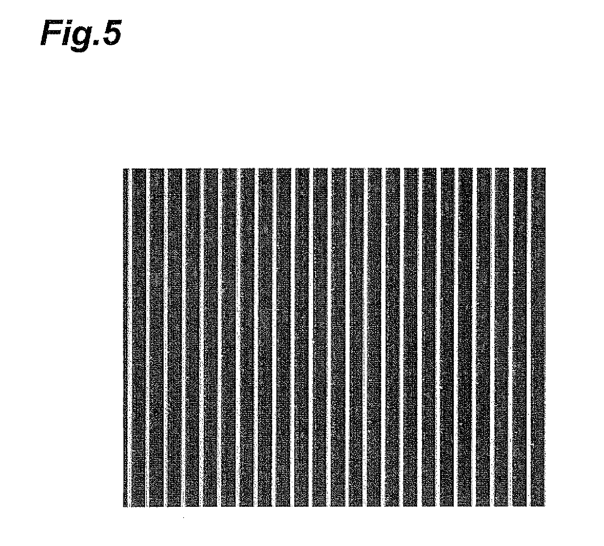

Figure 5 is a photograph of the appearance of a circuit-connection structure according to another embodiment of the present invention, taken from the LCD panel side. The circuit-connection structure is formed using a circuit-connecting material that contains, based on 100 parts by mass of an adhesive composition, 10 parts by mass of polyamic acid particles with a particle diameter of 2 µm, and 6 parts by mass of polystyrene-containing conductive particles with a particle diameter of 4 µm.

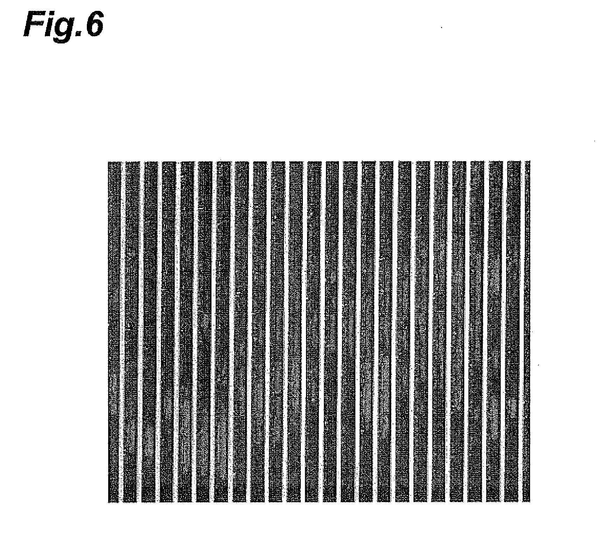

Figure 6 is a photograph of the appearance of a conventional circuit-connection structure, taken from the LCD panel side. The circuit-connection structure is formed using a circuit-connecting material that contains, based on 100 parts by mass of an adhesive composition, 10 parts by mass of a polystyrene-divinylbenzene copolymer with a particle diameter of 6 µm, and 6 parts by mass of polystyrene-containing conductive particles with a particle diameter of 4 µm.

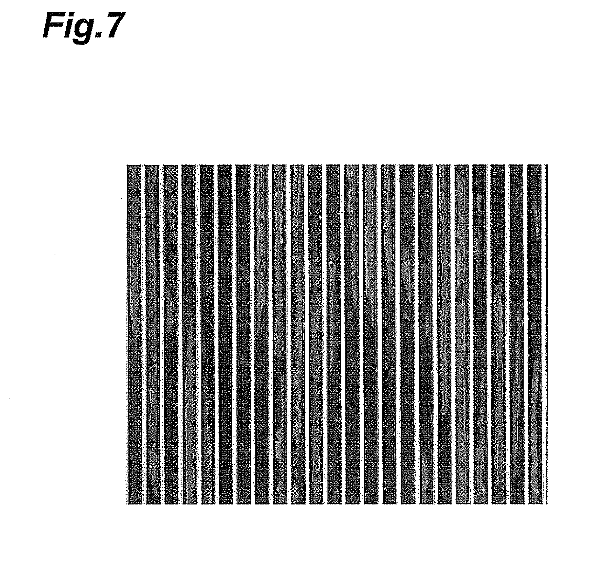

Figure 7 is a photograph of the appearance of another conventional circuit-connection structure, taken from the LCD panel side. The circuit-connection structure is formed using a circuit-connecting material that contains, based on 100 parts by mass of an adhesive composition, 10 parts by mass of silicone particles with a particle diameter of 2 µm, and 6 parts by mass of polystyrene-containing conductive particles with a particle diameter of 4 µm.

In each of the circuit-connection structures formed with conventional circuit-connecting materials (Figures 6 and 7), rainbow coloration (the white, faded portion in the photograph) occurs between neighboring electrodes on the LCD panel. This coloration phenomenon indicates that peeling has occurred at the interface between the circuit board and the circuit-connecting portion.

On the other hand, in each of the circuit-connection structures formed with the connecting materials for circuit components of the present invention (Figures 4 and 5), between neighboring electrodes on the LCD panel, no rainbow coloration (no white, faded portion in the photograph) occurs at the interface between the circuit board and the circuit-connecting portion. This can confirm that the use of the circuit-connecting materials of the present invention can prevent interfacial peeling between the circuit component and the circuit-connecting portion.

While embodiments of the present invention have been described in detail above, the invention is not limited by the foregoing embodiments.

For example, the circuit-connecting material can be divided into two or more layers, i.e., into a layer containing a reactive resin such as an epoxy resin and a layer containing a latent curing agent; or into a layer containing a curing agent that produces a free radical and a layer containing conductive particles. These structures can increase the definition and improve the pot life. In these cases, the insulating particles may be present in each layer or only one of the layers; however, the conductive particles are preferably present in the layer that contacts circuit components, to improve the connection reliability.

### Examples

The present invention will hereinafter be described in greater detail using Examples; however, the invention is not limited by these Examples.

### (Example 1)

Fifty parts by mass of polyester urethane resin (manufactured by Toyobo Co., Ltd.; tradename: UR8240) were dissolved in a mixed solvent of toluene/methyl ethyl ketone = 50/50 to prepare a solution with a concentration of the polyester urethane resin of 40% by mass. The solution was mixed with radically polymerizable substances and curing agents that produce free radicals, and stirred to give a solution of an adhesive composition (a binder resin).

As the radically polymerizable substances, 20 parts by mass of urethane acrylate (manufactured by Shin-Nakamura Chemical Corporation; tradename: UA-5500T); 20 parts by mass of bis(acryloxyethyl)isocyanurate (manufactured by Toagosei Co., Ltd.; tradename: M-215); 10 parts by mass of dimethylol tricyclodecane diacrylate (manufactured by Kyoeisha Chemical Co., Ltd.; tradename: DCP-A); and 3 parts by mass of 2-methacryloyloxyethyl acid phosphate (manufactured by Kyoeisha Chemical Co., Ltd.; tradename: P-2M) were used.

As the curing agents, 2 parts by mass of diacyl peroxide (NOF Corporation; tradename: PEROYL L) and 3 parts by mass of benzoyl peroxide (NOF Corporation; tradename: NYPER BMT) were used.

Subsequently, a 0.2-µm-thick nickel layer was formed on the surface of polystyrene particles with a mean particle diameter of 3.8 µm, and then a 0.04-µm-thick gold layer was further formed on the outer side of the nickel layer, thereby preparing conductive particles with a mean particle diameter of 4 µm having polystyrene particles as its core (10% compressive elasticity modulus (K-value): 410 Kgf/mm²).

Polyimide particles with a particle diameter of 3 µm (manufactured by Arakawa Chemical Industries, Ltd.; 10% compressive elasticity modulus (K-value): 390 Kgf/mm²) were then prepared as insulating particles.

To the solution of the binder resin prepared as above, 7.5 parts by mass of the insulating particles based on 50 parts by mass of the polyurethane resin; and 3% by volume of the conductive particles based on the binder resin were added and dispersed to give a dispersion.

The dispersion was applied, using a coating device Comma Coater, onto a 50-µm-thick PET film having one surface treated with a silicone, and then the dispersion was hot-air dried for 10 minutes at 70°C to give a circuit-connecting material (15 cm in width and 60 m in length) with a thickness of the adhesive layer of 18 µm.

The resulting circuit-connecting material was cut into a width of 1.2 mm, and 50 m of the material was wound around the circumferential surface (thickness: 1.5 mm) of a plastic reel with an inner diameter of 40 mm and an outer diameter of 48 mm, with the adhesive surface facing inside (the PET film side facing outside), thereby preparing a tape-like circuit-connecting material.

### (Example 2)

A tape-like circuit-connecting material was prepared in the same manner as Example 1, except that 4 parts by mass of diacyl peroxide (manufactured by NOF Corporation; tradename: PEROYL L) were used as a curing agent, without using benzoyl peroxide.

### (Example 3)

A tape-like circuit-connecting material was prepared in the same manner as Example 1, except that 5 parts by mass of benzoyl peroxide (manufactured by NOF Corporation; tradename: NYPER BMT) were used as a curing agent, without using diacyl peroxide.

### (Example 4)

A tape-like circuit-connecting material was prepared in the same manner as Example 1, except that 4 parts by mass of a peroxy ester (manufactured by NOF Corporation; tradename: PERHEXA 25O) were used instead of diacyl peroxide and benzoyl peroxide.

### (Example 5)

A tape-like circuit-connecting material was prepared in the same manner as Example 1, except that 5 parts by mass of an alkyl perester (manufactured by Hitachi Chemical Techno Service, Co. Ltd.; tradename: HTP-40) were used instead of diacyl peroxide and benzoyl peroxide.

### (Example 6)

A 0.2-µm-thick nickel layer was formed on the surface of polystyrene particles, and then a 0.04-µm-thick gold layer was further formed on the outer side of the nickel layer, thereby preparing conductive particles with a mean particle diameter of 3 µm having polystyrene particles as its core (10% compressive elasticity modulus (K-value): 410 Kgf/mm²).

A tape-like circuit-connecting material was prepared in the same manner as Example 1, except that 3% by volume of the conductive particles with a mean particle diameter of 3 µm prepared as above were added as conductive particles into the binder resin, instead of the conductive particles with a mean particle diameter of 4 µm.

### (Example 7)

A 0.2-µm-thick nickel layer was formed on the surface of polystyrene particles, and then a 0.04-µm-thick gold layer was further formed on the outer side of the nickel layer, thereby preparing conductive particles with a mean particle diameter of 5 µm having polystyrene particles as its core (10% compressive elasticity modulus (K-value): 410 Kgf/mm²).

A tape-like circuit-connecting material was prepared in the same manner as Example 1, except that 3% by volume of the conductive particles with a mean particle diameter of 5 µm prepared as above were added as conductive particles into the binder resin, instead of the conductive particles with a mean particle diameter of 4 µm.

### (Example 8)

A tape-like circuit-connecting material was prepared in the same manner as Example 1, except that polyimide particles with a particle diameter of 0.5 µm (manufactured by Arakawa Chemical Industries, Ltd.; 10% compressive elasticity modulus (K-value): 480 Kgf/mm²) were used as insulating particles, instead of the polyimide particles with a particle diameter of 3 µm.

### (Example 9)

A tape-like circuit-connecting material was prepared in the same manner as Example 1, except that polyimide particles with a particle diameter of 2 µm (manufactured by Arakawa Chemical Industries, Ltd.; 10% compressive elasticity modulus (K-value): 450 Kgf/mm²) were used as insulating particles, instead of the polyimide particles with a particle diameter of 3 µm.

### (Example 10)

A tape-like circuit-connecting material was prepared in the same manner as Example 1, except that polyimide particles with a particle diameter of 5 µm (manufactured by Arakawa Chemical Industries, Ltd.; 10% compressive elasticity modulus (K-value): 390 Kgf/mm²) were used as insulating particles, instead of the polyimide particles with a particle diameter of 3 µm.

### (Example 11)

A tape-like circuit-connecting material was prepared in the same manner as Example 1, except that polyimide particles with a particle diameter of 10 µm (manufactured by Arakawa Chemical Industries, Ltd.; 10% compressive elasticity modulus (K-value): 390 Kgf/mm²) were used as insulating particles, instead of the polyimide particles with a particle diameter of 3 µm.

### (Example 12)

A tape-like circuit-connecting material was prepared in the same manner as Example 1, except that polyamic acid particles with a particle diameter of 2 µm (manufactured by Arakawa Chemical Industries, Ltd.; 10% compressive elasticity modulus (K-value): 430 Kgf/mm²) were used as insulating particles, instead of the polyimide particles with a particle diameter of 3 µm.

### (Examples 13 to 15 and 17 to 20)

Tape-like circuit-connecting materials were prepared in the same manner as Example 1, except that the amounts of the insulating particles used, i.e., the polyimide particles with a particle diameter of 3 µm (manufactured by Arakawa Chemical Industries, Ltd.), were changed as shown in Table 1.

### (Example 16)

A tape-like circuit-connecting material was prepared in the same manner as Example 1, except that the amount of the insulating particles used, i.e., the polyimide particles with a particle diameter of 3 µm (manufactured by Arakawa Chemical Industries, Ltd.), was changed to 10 parts by mass, and 3% by volume of the conductive particles with a mean particle diameter of 3 µm prepared in Example 6 (10% compressive elasticity modulus (K-value): 410 Kgf/mm²) were further added to the binder resin.

### (Comparative Example 1)

A tape-like circuit-connecting material was prepared in the same manner as Example 1, except that insulating particles were not used.

### (Comparative Example 2)

A tape-like circuit-connecting material was prepared in the same manner as Example 3, except that insulating particles were not used.

### (Comparative Example 3)

A tape-like circuit-connecting material was prepared in the same manner as Example 1, except that 10 parts by mass of particles composed of a polystyrene-divinylbenzene copolymer with a particle diameter of 6 µm (manufactured by Matsuura & Co., LTD.; tradename: PB3006; 10% compressive elasticity modulus (K-value): 320 Kgf/mm²) were used as insulating particles, instead of the polyimide particles with a particle diameter of 3 µm.

### (Comparative Example 4)

A tape-like circuit-connecting material was prepared in the same manner as Example 1, except that 10 parts by mass of particles composed of a polystyrene-divinylbenzene copolymer with a particle diameter of 10 µm (manufactured by Matsuura & Co., LTD.; tradename: PB3011D; 10% compressive elasticity modulus (K-value): 250 Kgf/mm²) were used as insulating particles, instead of the polyimide particles with a particle diameter of 3 µm.

### (Comparative Example 5)

A tape-like circuit-connecting material was prepared in the same manner as Example 1, except that 10 parts by mass of particles composed of a silicone with a particle diameter of 2 µm (a silicone manufactured by Dow Coming Toray Co., Ltd.; tradename: E-605; 10% compressive elasticity modulus (K-value): 30 Kgf/mm²) were used as insulating particles, instead of the polyimide particles with a particle diameter of 3 µm.

### (Comparative Example 6)

A tape-like circuit-connecting material was prepared in the same manner as Example 1, except that 10 parts by mass of particles composed of a silicone with a particle diameter of 2 µm (manufactured by Shin-Etsu Chemical Co. Ltd.; tradename: KMP605; 10% compressive elasticity modulus (K-value): 35 Kgf/mm²) were used as insulating particles, instead of the polyimide particles with a particle diameter of 3 µm.

### (Comparative Example 7)

A tape-like circuit-connecting material was prepared in the same manner as Example 1, except that 10 parts by mass of particles composed of a methacrylate copolymer with a particle diameter of 1.5 µm (manufactured by Soken Chemical and Engineering Co., Ltd.; tradename: MX150; 10% compressive elasticity modulus (K-value): 400 Kgf/mm²) were used as insulating particles, instead of the polyimide particles with a particle diameter of 3 µm.

### (Comparative Example 8)

A tape-like circuit-connecting material was prepared in the same manner as Example 1, except that 10 parts by mass of particles composed of a methacrylate copolymer with a particle diameter of 3 µm (manufactured by Soken Chemical and Engineering Co., Ltd.; tradename: MX300; 10% compressive elasticity modulus (K-value): 350 Kgf/mm²) were used as insulating particles, instead of the polyimide particles with a particle diameter of 3 µm.

### (Comparative Example 9)

A tape-like circuit-connecting material was prepared in the same manner as Example 1, except that 10 parts by mass of particles composed of a methacrylate copolymer with a particle diameter of 5 µm (manufactured by Soken Chemical and Engineering Co., Ltd.; tradename: MX500; 10% compressive elasticity modulus (K-value): 330 Kgf/mm²) were used as insulating particles, instead of the polyimide particles with a particle diameter of 3 µm.

### (Comparative Example 10)

A tape-like circuit-connecting material was prepared in the same manner as Example 1, except that 10 parts by mass of particles composed of an alkyl acrylate-alkyl methacrylate copolymer with a particle diameter of 0.1 µm (manufactured by Ganz Chemical Co., Ltd.; tradename: AC3364P; 10% compressive elasticity modulus (K-value): 100 Kgf/mm²) were used as insulating particles, instead of the polyimide particles with a particle diameter of 3 µm.

### <Preparation of Circuit-Connection Structures for Evaluation of Interfacial Peeling>

First, each of the circuit-connecting materials prepared in the Examples and Comparative Examples was cut into a predetermined size (1.2 mm in width and 3 cm in length). A 50-µm-pitch glass substrate was prepared wherein, on a 1.1-mm-thick soda lime glass, an SiO₂ film and an ITO film with a surface resistance of 10 to 15 Ω/□ were formed, and Cr was further formed on the surface thereof. The glass substrate and the adhesive surface of each circuit-connecting material cut into the predetermined size were brought into contact so that they were opposed to each other, after which heat and pressure were applied thereto for 2 seconds at 70°C and 1 MPa, thereby transferring the circuit-connecting material onto the glass substrate. The PET film on the transferred circuit-connecting material was subsequently removed.

Then, the transferred circuit-connecting material and a flexible circuit board (FPC) having six-hundred 8-µm-thick tinned copper circuits (pitch: 50 µm) were brought into contact so that the glass substrate and the electrodes on the FPC were opposed, after which they were temporarily fixed by applying pressure for 1 second at 24°C and 0.5 MPa. In this way, a laminate having the circuit-connecting material interposed between the glass substrate and the FPC was prepared.

The laminate was set on a permanent pressure-bonding device in such a manner that pressure was applied in the laminate direction of the glass substrate, the circuit-connecting material, and FPC. Using 200-µm-thick silicone rubber as a cushioning material, heat and pressure were applied to the laminate for 7 seconds at 160°C and 3 MPa using a heating device, thereby producing a circuit-connection structure for evaluation of interfacial peeling.

### (Evaluation of Interfacial Peeling)

The resulting circuit-connection structures were evaluated for the presence or absence of interfacial peeling as follows. Each of the circuit-connection structures was observed under an optical microscope (manufactured by Olympus Corporation; tradename: BH2-MJL) from the glass substrate side. Between neighboring ITO electrodes on the glass substrate, when rainbow coloration was observed at the interface between the glass substrate and the circuit-connecting portion, the circuit-connection structure was evaluated as having interfacial peeling; and when no rainbow coloration was observed at the interface between the glass substrate and the circuit-connecting portion, the circuit-connection structure was evaluated as being free of interfacial peeling.

### <Preparation of Circuit-Connection Structures for Evaluation of Connection Resistance and Adhesion>

First, each of the circuit-connecting materials prepared in the Examples and Comparative Examples was cut into a predetermined size (1.2 mm in width and 3 cm in length). The adhesive surface of each circuit-connecting material cut into the predetermined size and the surface of an ITO-coated glass substrate (surface resistance: 15 Ω/□) on which electrodes were formed were brought into contact so that they were opposed to each other, after which heat and pressure were applied thereto for 2 seconds at 70°C and 1 MPa, thereby transferring the circuit-connecting material onto the ITO-coated glass substrate. The PET film on the transferred circuit-connecting material was subsequently removed.

Then, the transferred circuit-connecting material and a flexible circuit board (FPC) having six-hundred 8-µm-thick tinned copper circuits (pitch: 50 µm) were brought into contact so that the ITO-coated glass substrate and the electrodes on the FPC were opposed, after which they were temporarily fixed by applying pressure for 1 second at 24°C and 0.5 MPa. In this way, a laminate having the circuit-connecting material interposed between the ITO-coated glass substrate and the FPC was prepared.

The resulting laminate was set on a permanent pressure-bonding device in such a manner that pressure was applied in the laminate direction of the ITO-coated glass substrate, the circuit-connecting material, and FPC. Using 200-µm-thick silicone rubber as a cushioning material, heat and pressure were applied to the laminate using a heating device for 7 seconds at 160°C and 3 MPa, thereby producing a circuit-connection structure for evaluation of the surface resistance and adhesion.

### (Measurement of Adhesion)

The strength needed to peel the FPC from each of the circuit-connection structures prepared for evaluation of adhesion was measured as the adhesion. Measurements were made according to JIS Z-0237: the adhesion was measured by peeling at an angle of 90° and a peeling speed of 50 mm/min, using an adhesion measuring device (manufactured by Orientec Co, Ltd.; tradename: Tensilon RTM-50). Tables 1 and 2 show the results.

### (Measurement of Connection Resistance)

In order to measure the resistance value between the circuits including the circuit-connecting portion, using each of the circuit-connection structures prepared for evaluation of the connection resistance, the resistance value between neighboring circuits on the FPC was measured using a multimeter (device name: TR6845, manufactured by Advantest Corporation). Measurements were made at 40 points between different neighboring circuits, and the average value of the measured values was determined as the connection resistance. Tables 1 and 2 show the connection resistances.

**[Table 1]**

| Examples | | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|---|
| Thermoplastic Resin (parts by mass) | UR8240 | 50 | 50 | 50 | 50 | 50 | 50 | 50 | 50 | 50 | 50 | 50 | 50 | 50 | 50 | 50 | 50 | 50 | 50 | 50 | 50 |
| Thermosetting Resin (parts by mass) | M-215 | 20 | 20 | 20 | 20 | 20 | 20 | 20 | 20 | 20 | 20 | 20 | 20 | 20 | 20 | 20 | 20 | 20 | 20 | 20 | 20 |
| | UA-5500T | 20 | 20 | 20 | 20 | 20 | 20 | 20 | 20 | 20 | 20 | 20 | 20 | 20 | 20 | 20 | 20 | 20 | 20 | 20 | 20 |
| | DCP-A | 10 | 10 | 10 | 10 | 10 | 10 | 10 | 10 | 10 | 10 | 10 | 10 | 10 | 10 | 10 | 10 | 10 | 10 | 10 | 10 |
| | P-2M | 3 | 3 | 3 | 3 | 3 | 3 | 3 | 3 | 3 | 3 | 3 | 3 | 3 | 3 | 3 | 3 | 3 | 3 | 3 | 3 |
| Curing Agent (parts by mass) | PEROYL L | 2 | 4 | 0 | 0 | 0 | 2 | 2 | 2 | 2 | 2 | 2 | 2 | 2 | 2 | 2 | 2 | 2 | 2 | 2 | 2 |
| | NYPER BMT | 3 | 0 | 5 | 0 | 0 | 3 | 3 | 3 | 3 | 3 | 3 | 3 | 3 | 3 | 3 | 3 | 3 | 3 | 3 | 3 |
| | PERHEXA 250 | 0 | 0 | 0 | 4 | 0 | 0 | 0 | 0 | 0 | 0 | 0 | 0 | 0 | 0 | 0 | 0 | 0 | 0 | 0 | 0 |
| | HTP-40 | 0 | 0 | 0 | 0 | 5 | 0 | 0 | 0 | 0 | 0 | 0 | 0 | 0 | 0 | 0 | 0 | 0 | 0 | 0 | 0 |
| Insulating Particles (parts by mass) | 3 µm Polyimide Particles | 7.5 | 7.5 | 7.5 | 7.5 | 7.5 | 7.5 | 7.5 | 0 | 0 | 0 | 0 | 0 | 0.5 | 1 | 5 | 10 | 15 | 20 | 30 | 50 |
| | 0.5 µm Polyimide Particles | 0 | 0 | 0 | 0 | 0 | 0 | 0 | 7.5 | 0 | 0 | 0 | 0 | 0 | 0 | 0 | 0 | 0 | 0 | 0 | 0 |
| | 2 µm Polyimide Particles | 0 | 0 | 0 | 0 | 0 | 0 | 0 | 0 | 7.5 | 0 | 0 | 0 | 0 | 0 | 0 | 0 | 0 | 0 | 0 | 0 |
| | 5 µm Polyimide Particles | 0 | 0 | 0 | 0 | 0 | 0 | 0 | 0 | 0 | 7.5 | 0 | 0 | 0 | 0 | 0 | 0 | 0 | 0 | 0 | 0 |
| | 10 µm Polyimide Particles | 0 | 0 | 0 | 0 | 0 | 0 | 0 | 0 | 0 | 0 | 7.5 | 0 | 0 | 0 | 0 | 0 | 0 | 0 | 0 | 0 |
| | 2 µm Polyamic Acid Particles | 0 | 0 | 0 | 0 | 0 | 0 | 0 | 0 | 0 | 0 | 0 | 7.5 | 0 | 0 | 0 | 0 | 0 | 0 | 0 | 0 |
| | PB3006 | 0 | 0 | 0 | 0 | 0 | 0 | 0 | 0 | 0 | 0 | 0 | 0 | 0 | 0 | 0 | 0 | 0 | 0 | 0 | 0 |
| | PB3011D | 0 | 0 | 0 | 0 | 0 | 0 | 0 | 0 | 0 | 0 | 0 | 0 | 0 | 0 | 0 | 0 | 0 | 0 | 0 | 0 |
| | E-605 | 0 | 0 | 0 | 0 | 0 | 0 | 0 | 0 | 0 | 0 | 0 | 0 | 0 | 0 | 0 | 0 | 0 | 0 | 0 | 0 |
| | KMP-605 | 0 | 0 | 0 | 0 | 0 | 0 | 0 | 0 | 0 | 0 | 0 | 0 | 0 | 0 | 0 | 0 | 0 | 0 | 0 | 0 |
| | MX150 | 0 | 0 | 0 | 0 | 0 | 0 | 0 | 0 | 0 | 0 | 0 | 0 | 0 | 0 | 0 | 0 | 0 | 0 | 0 | 0 |
| | MX300 | 0 | 0 | 0 | 0 | 0 | 0 | 0 | 0 | 0 | 0 | 0 | 0 | 0 | 0 | 0 | 0 | 0 | 0 | 0 | 0 |
| | MX500 | 0 | 0 | 0 | 0 | 0 | 0 | 0 | 0 | 0 | 0 | 0 | 0 | 0 | 0 | 0 | 0 | 0 | 0 | 0 | 0 |
| | AC-3364P | 0 | 0 | 0 | 0 | 0 | 0 | 0 | 0 | 0 | 0 | 0 | 0 | 0 | 0 | 0 | 0 | 0 | 0 | 0 | 0 |
| Conductive Particles (Note 1) | 3 µM Conductive Particles | 0 | 0 | 0 | 0 | 0 | 3 | 0 | 0 | 0 | 0 | 0 | 0 | 0 | 0 | 0 | 3 | 0 | 0 | 0 | 0 |
| | 4 µm Conductive Particles | 3 | 3 | 3 | 3 | 3 | 0 | 0 | 3 | 3 | 3 | 3 | 3 | 3 | 3 | 3 | 3 | 3 | 3 | 3 | 3 |
| | 5 µm Conductive Particles | 0 | 0 | 0 | 0 | 0 | 0 | 3 | 0 | 0 | 0 | 0 | 0 | 0 | 0 | 0 | 0 | 0 | 0 | 0 | 0 |
| Interfacial Peeling | | No | No | No | No | No | No | No | No | No | No | No | No | No | No | No | No | No | No | No | No |
| Adhesion (N/m) | | 923 | 785 | 1023 | 685 | 932 | 905 | 935 | 793 | 902 | 934 | 938 | 812 | 934 | 928 | 921 | 912 | 781 | 623 | 432 | 325 |
| Connection Resistance (Ω) | | 1.2 | 1.1 | 1.3 | 1.1 | 1.2 | 1.3 | 1.1 | 1.2 | 1.2 | 1.3 | 1.4 | 1.2 | 1.2 | 1.2 | 1.2 | 1.3 | 1.4 | 1.5 | 1.9 | 2.5 |

| | | | | | | | | | | | | | | | | | | | | | |
|---|---|---|---|---|---|---|---|---|---|---|---|---|---|---|---|---|---|---|---|---|---|
| (Note 1) The numerical values are shown in % by volume based on the binder resin. | | | | | | | | | | | | | | | | | | | | | |

**[Table 2]**

| Comparative Examples | | 1 | 2 | 3 | 4 | 5 | 6 | 7 | 8 | 9 | 10 |
|---|---|---|---|---|---|---|---|---|---|---|---|
| Thermoplastic Resin (parts by mass) | UR8240 | 50 | 50 | 50 | 50 | 50 | 50 | 50 | 50 | 50 | 50 |
| Thermosetting Resin (parts by mass) | M-215 | 20 | 20 | 20 | 20 | 20 | 20 | 20 | 20 | 20 | 20 |
| | UA-5500T | 20 | 20 | 20 | 20 | 20 | 20 | 20 | 20 | 20 | 20 |
| | DCP-A | 10 | 10 | 10 | 10 | 10 | 10 | 10 | 10 | 10 | 10 |
| | P-2M | 3 | 3 | 3 | 3 | 3 | 3 | 3 | 3 | 3 | 3 |
| Curing Agent (parts by mass) | PEROYLL | 2 | 0 | 2 | 2 | 2 | 2 | 2 | 2 | 2 | 2 |
| | NYPER BMT | 3 | 5 | 3 | 3 | 3 | 3 | 3 | 3 | 3 | 3 |
| | PERHEXA 25O | 0 | 0 | 0 | 0 | 0 | 0 | 0 | 0 | 0 | 0 |
| | HTP-40 | 0 | 0 | 0 | 0 | 0 | 0 | 0 | 0 | 0 | 0 |
| Insulating Particles (parts by mass) | 3 µm Polyimide Particles | 0 | 0 | 0 | 0 | 0 | 0 | 0 | 0 | 0 | 0 |
| | 0.5 µm Polyimide Particles | 0 | 0 | 0 | 0 | 0 | 0 | 0 | 0 | 0 | 0 |
| | 2 µm Polyimide Particles | 0 | 0 | 0 | 0 | 0 | 0 | 0 | 0 | 0 | 0 |
| | 5 µm Polyimide Particles | 0 | 0 | 0 | 0 | 0 | 0 | 0 | 0 | 0 | 0 |
| | 10 µm Polyimide Particles | 0 | 0 | 0 | 0 | 0 | 0 | 0 | 0 | 0 | 0 |
| | 2 µm Polyamic Acid Particles | 0 | 0 | 0 | 0 | 0 | 0 | 0 | 0 | 0 | 0 |
| | PB3006 | 0 | 0 | 10 | 0 | 0 | 0 | 0 | 0 | 0 | 0 |
| | PB3011D | 0 | 0 | 0 | 10 | 0 | 0 | 0 | 0 | 0 | 0 |
| | E-605 | 0 | 0 | 0 | 0 | 10 | 0 | 0 | 0 | 0 | 0 |
| | KMP-605 | 0 | 0 | 0 | 0 | 0 | 10 | 0 | 0 | 0 | 0 |
| | MX150 | 0 | 0 | 0 | 0 | 0 | 0 | 10 | 0 | 0 | 0 |
| | MX300 | 0 | 0 | 0 | 0 | 0 | 0 | 0 | 10 | 0 | 0 |
| | MX500 | 0 | 0 | 0 | 0 | 0 | 0 | 0 | 0 | 10 | 0 |
| | AC-3364P | 0 | 0 | 0 | 0 | 0 | 0 | 0 | 0 | 0 | 10 |
| Conductive Particles (Note 1) | 3 µm Conductive Particles | 0 | 0 | 0 | 0 | 0 | 0 | 0 | 0 | 0 | 0 |
| | 4 µm Conductive Particles | 3 | 3 | 3 | 3 | 3 | 3 | 3 | 3 | 3 | 3 |
| | 5 µm Conductive Particles | 0 | 0 | 0 | 0 | 0 | 0 | 0 | 0 | 0 | 0 |
| Interfacial Peeling | | Yes | Yes | Yes | Yes | Yes | Yes | Yes | Yes | Yes | Yes |
| Adhesion (N/m) | | 903 | 1115 | 912 | 915 | 921 | 935 | 923 | 890 | 905 | 889 |
| Connection Resistance (Ω) | | 1.2 | 1.2 | 1.2 | 1.4 | 1.2 | 1.2 | 1.3 | 1.2 | 1.3 | 1.2 |

| | | | | | | | | | | | |
|---|---|---|---|---|---|---|---|---|---|---|---|
| (Note 1) The numerical values are shown in % by volute based on the binder resin. | | | | | | | | | | | |

### Industrial Applicability

As described above, the present invention provides a circuit-connecting material that provides excellent connection reliability and an excellent connection appearance by preventing interfacial peeling between a circuit component and a circuit-connecting portion while maintaining high conductivity between opposing electrodes and high adhesion between opposing circuit components; a connection structure of circuit components using the circuit-connecting material; and a method for producing the connection structure of circuit components.

## Claims

1. A circuit-connecting material for connecting a first circuit component having a plurality of first circuit electrodes on a main surface of a first circuit board and a second circuit component having a plurality of second circuit electrodes on a main surface of a second circuit board, in such a manner that the first circuit electrodes and the second circuit electrodes are electrically connected while being opposed to one another, the circuit-connecting material comprising:
an adhesive composition;
conductive particles; and
a plurality of insulating particles containing one or both of polyamic acid particles and polyimide particles.

2. The circuit-connecting material according to Claim 1, wherein the mass ratio of the insulating particles to the adhesive composition is from 0.001 to 0.5.

3. The circuit-connecting material according to Claim 1, wherein the mean particle diameter of the insulating particles is greater than that of the conductive particles.

4. The circuit-connecting material according to Claim 1, wherein the mean particle diameter of the insulating particles is from 0.1 to 10 µm.

5. The circuit-connecting material according to Claim 1, wherein the insulating particles have a 10% compressive elasticity modulus that is lower than that of the conductive particles.

6. The circuit-connecting material according to Claim 1, wherein the insulating particles contain polyamic acid particles.

7. A connection structure of circuit components comprising:
a first circuit component having a plurality of first circuit electrodes on a main surface of a first circuit board;
a second circuit component having a plurality of second circuit electrodes on a main surface of a second circuit board, the second circuit electrodes being located so that they are opposed to the first circuit electrodes; and
a circuit-connecting portion provided between the first circuit board and the second circuit board, to connect the first circuit component and the second circuit component in such a manner that the first and second circuit electrodes are electrically connected;
wherein the circuit-connecting portion is made of the circuit-connecting material of any one of Claims 1 to 6.

8. A method for producing a connection structure of circuit components, comprising the steps of:
locating a first circuit component having a plurality of first circuit electrodes on a main surface of a first circuit board and a second circuit component having a plurality of second circuit electrodes on a main surface of a second circuit board so that the first circuit electrodes and the second circuit electrodes are opposed to one another; and
applying heat and pressure to the entire resulting structure, with the circuit-connecting material of any one of Claims 1 to 6 being interposed between the first and second circuit components, thereby connecting the first circuit component and the second circuit component in such a manner that the first and second circuit electrodes are electrically connected.
